# FASCICULE DE BREVET EUROPEEN

(11) **EP 3 221 881 B1**
(45) Date de publication et mention de la délivrance du brevet: **06.11.2019**
(21) Numéro de dépôt: 15797989.9
(22) Date de dépôt: 17.11.2015
(51) Int. Cl.: H01L 21/02, H01L 33/12, H01L 29/778, H01L 29/10, H01L 29/207, H01L 33/32

(54) **STRUCTURE SEMI-CONDUCTRICE A COUCHE DE SEMI-CONDUCTEUR DU GROUPE III-V COMPRENANT UNE STRUCTURE CRISTALLINE A MAILLES HEXAGONALES**
HALBLEITERSTRUKTUR MIT EINER HALBLEITERSCHICHT DER GRUPPE III-V UMFASSEND EINE KRISTALLSTRUKTUR MIT EINEM HEXAGONALEN GITTER
SEMICONDUCTOR STRUCTURE HAVING A GROUP III-V SEMICONDUCTOR LAYER COMPRISING A CRYSTALLINE STRUCTURE HAVING AN HEXAGONAL LATTICE

(30) Priorité: 18.11.2014 FR 1461109
(43) Date de publication de la demande: 27.09.2017
(60) Demande divisionnaire: 18152694.8
(73) Titulaire: Commissariat à l'Énergie Atomique et aux Énergies Alternatives, 75015 Paris (FR)
(72) Inventeur: CHARLES, Matthew, F-38000 Grenoble (FR)
(74) Mandataire: Brevalex
(86) Numéro de dépôt international: PCT/EP2015/076816
(87) Numéro de publication internationale: WO 2016/079115

(56) Documents cités:
- EP-A1- 2 565 907
- EP-A1- 2 565 907
- US-A1- 2008 203 382
- US-A1- 2008 203 382
- US-A1- 2010 244 096
- US-A1- 2010 244 096

## Description

### DOMAINE TECHNIQUE ET ART ANTÉRIEUR

Il est décrit ici une structure semi-conductrice comportant une couche de semi-conducteur du groupe III-V de structure cristalline à mailles hexagonales et comprenant un paramètre de maille, ou paramètre cristallin, différent de celui du matériau du substrat sur lequel est formé cette couche, ainsi qu'un procédé de réalisation d'une telle structure semi-conductrice. Il est également décrit un ou plusieurs dispositifs semi-conducteurs réalisés à partir d'une telle structure semi-conductrice, comme par exemple des transistors tels que des transistors de type HEMT (« High Electron Mobility Transistor », ou transistor à haute mobilité électronique) ou des diodes électroluminescentes comprenant par exemple un ou plusieurs puits quantiques en semi-conducteur.

Parmi les différents semi-conducteurs existants, les semi-conducteurs du groupe III-V ou II-VI de structure cristalline à mailles cubiques ou hexagonales, et particulièrement le GaN, sont intéressants pour réaliser des dispositifs électroniques de grande qualité. Pour obtenir du GaN à un coût raisonnable, il est possible de réaliser une croissance de GaN par hétéro-épitaxie sur un substrat de nature différente tel qu'un substrat de silicium ou de saphir.

Ces matériaux tels que le silicium et le saphir comportent toutefois des paramètres de maille et des coefficients de dilatation thermique (« coefficient of thermal expansion» en anglais, ou CTE) différents de ceux du GaN. Ainsi, une croissance de GaN par épitaxie directement sur un substrat de silicium ou de saphir génère d'importants défauts cristallins dans le GaN tels que des dislocations.

Pour éviter l'apparition de ces défauts lors d'une croissance de GaN, il est nécessaire de faire croître au préalable sur le substrat une couche tampon sur laquelle le GaN est ensuite réalisé, cette couche tampon servant de couche de nucléation pour le GaN et permettant de modifier la contrainte dans le GaN. Une telle couche tampon correspond par exemple à une couche d'AlN permettant de réduire la différence entre le paramètre de maille du GaN et celui du matériau du substrat. Cependant, avec une simple couche tampon d'AlN, l'épaisseur de GaN de bonne qualité pouvant être obtenue est très limitée.

Pour réaliser une croissance d'une couche épaisse de GaN de bonne qualité sur du silicium, il est important que le GaN ne soit pas directement en contact avec le silicium et que le GaN soit formé avec une contrainte compressive de sorte que lors d'un refroidissement ultérieur à l'épitaxie du GaN, la couche de GaN ne se fissure pas à cause de la différence de CTE entre le GaN et le silicium. Etant donné que les dislocations dans les couches permettent une certaine relaxation, une diminution de la densité de dislocations dans la couche de GaN permet de la conserver en compression plus longtemps. De même, si des couches sont successivement réalisées par croissance et permettent de mettre le GaN en compression, cela provoque une remise à zéro des états de contrainte dans le GaN, et la plaque a alors une courbure nulle à température ambiante.

Le document US 2002/0074552 A1 décrit la réalisation d'une croissance de GaN sur un substrat de silicium via l'utilisation d'une structure tampon comprenant une première couche d'AlN et une couche d'AlGaN dont le taux de gallium augmente graduellement avec son épaisseur, de manière continue ou par palliés. Une telle couche tampon d'AlGaN dont la composition de gallium varie avec son épaisseur permet de mettre en compression le GaN. Toutefois, la réduction du nombre de dislocations dans le GaN formé sur une telle couche tampon reste insuffisante, et la tenue en tension pouvant être obtenue avec un tel matériau n'est pas suffisante non plus.

Il est également décrit dans le document US 2002/0074552 A1, ainsi que dans le document US 2012/0223328 A1, l'utilisation d'une structure tampon formée d'une alternance de couches d'AlGaN dont le taux de gallium est différent d'une couche à l'autre. Une telle structure tampon est appelée super-réseau (« superlattice » en anglais).

L'objectif de cette structure est de faire croître une couche relaxée avec un faible paramètre de maille (par exemple de l'AlN) sur une épaisseur de quelques nanomètres, puis de réaliser une couche en compression sur une épaisseur de plusieurs dizaines de nanomètres avec un paramètre de maille plus grand.

Un tel super-réseau permet d'obtenir une meilleure tenue en tension pour une couche résistive, mais ne permet pas de réduire suffisamment le taux de dislocations dans la couche finale de GaN.

Les problèmes exposés ci-dessus pour le GaN se retrouvent également lors de la croissance d'autres semi-conducteurs du groupe III-V ou II-VI et comprenant une structure cristalline à mailles cubiques ou hexagonales, sur un substrat dont le matériau présente un paramètre de maille différent de celui du semi-conducteur formé par croissance.

Les documents US2008/203382 A1, US2010/244096 A1 et EP2565907 A1 décrivent des structures semi-conductrices comprenant des empilements de couches d'AlₓGa_{y}In_{(1-x-y)}N.

### EXPOSÉ DE L'INVENTION

Un but de la présente invention est de proposer une structure semi-conductrice comportant une couche de semi-conducteur du groupe III-V et comprenant une structure cristalline à mailles hexagonales, sur un substrat comprenant un matériau présentant un paramètre de maille différent de celui du semi-conducteur, et dont le compromis qualité du semi-conducteur / compression / tenue en tension soit meilleur que celui pouvant être obtenu avec les structures semi-conductrices de l'art antérieur.

De manière générale, il est décrit dans ce document une structure semi-conductrice comportant au moins :
- un substrat,
- une première couche de semi-conducteur du groupe III-V ou II-VI et comprenant une structure cristalline à mailles cubiques ou hexagonales, disposée sur le substrat et telle que ledit semi-conducteur comprend un paramètre de maille différent de celui du matériau du substrat,
- un premier empilement de plusieurs deuxièmes et troisièmes couches disposées de manière alternée l'une contre l'autre, entre le substrat et la première couche, et comportant ledit semi-conducteur,
et dans lequel :
- le taux d'un élément du semi-conducteur des deuxièmes couches varie de manière croissante d'une deuxième couche à l'autre selon une direction allant du substrat à la première couche,
- le taux dudit élément du semi-conducteur des troisièmes couches varie de manière décroissante d'une troisième couche à l'autre selon ladite direction et tel qu'une valeur d'un paramètre de maille moyen de chaque groupe d'une deuxième et d'une troisième couches adjacentes soit sensiblement constante dans le premier empilement lorsque ladite structure cristalline comprend des mailles cubiques, ou, lorsque ladite structure cristalline comprend des mailles hexagonales, le taux dudit élément du semi-conducteur des troisièmes couches est sensiblement constant ou varie de manière décroissante d'une troisième couche à l'autre selon ladite direction tel que le paramètre de maille moyen de chaque groupe d'une deuxième et d'une troisième couches adjacentes ait une valeur variant de manière croissante d'un groupe à l'autre du premier empilement selon ladite direction,
- l'épaisseur de chacune des deuxièmes et troisièmes couches est inférieure à environ 5 nm. Les structures non conformes à la revendication 1 ne font pas partie de l'invention.

Pour résoudre le problème technique mentionné ci-dessus, l'invention propose une structure semi-conductrice conformément à la revendication 1.

Comme les super-réseaux de l'art antérieur, les premier et deuxième empilements d'une telle structure semi-conductrice comportent un grand nombre d'interfaces entre des couches de compositions différentes, ce qui permet de réduire la densité de dislocations se formant au sein de la structure. De plus, la valeur moyenne du paramètre de maille au sein des premier et deuxième empilements varie de manière croissante ou reste constante, ce qui permet de maintenir une bonne compression dans les matériaux comprenant une structure cristalline à mailles hexagonales et d'éviter une contrainte dans les matériaux comprenant une structure cristalline à mailles cubiques.

Les premier et deuxième empilements des deuxièmes et troisièmes couches inclus dans cette structure semi-conductrice permettent d'avoir une première couche comportant, à épaisseur équivalente, une meilleure qualité que dans les structures de l'art antérieur, tout en conservant une bonne contrainte en compression au sein des différentes couches de la structure. De manière analogue, pour une qualité de semi-conducteur donnée (qualité du semi-conducteur de la première couche), cette structure permet d'avoir une première couche de semi-conducteur d'épaisseur supérieure à celle pouvant être obtenue avec les structures de l'art antérieur.

En outre, par rapport aux couches tampon de l'art antérieur utilisées et pour une même qualité du semi-conducteur final obtenu (semi-conducteur de la première couche), l'épaisseur totale des couches se trouvant entre le substrat et la première couche peut être inférieure à celles des couches tampon de l'art antérieur, pour les mêmes performances électriques, ce qui se traduit par un gain sur l'encombrement, et un coût de réalisation inférieur à ceux des structures de l'art antérieur. De plus, du fait qu'une augmentation de l'épaisseur totale des couches formées sur le substrat augmente la fragilité des plaques, cette réduction d'épaisseur permet d'améliorer la robustesse des plaques produites.

Le taux d'un élément du semi-conducteur des deuxièmes couches, c'est-à-dire le taux de gallium du semi-conducteur des deuxièmes couches dans le cas de l'invention, varie de manière croissante d'une deuxième couche à l'autre selon une direction allant du substrat à la première couche. Autrement dit, en considérant deux deuxièmes couches au sein du premier empilement, le taux de cet élément dans l'une de ces deux deuxièmes couches qui est la plus proche du substrat est inférieur au taux de cet élément dans l'autre de ces deux deuxièmes couches.

Lorsque la structure cristalline du semi-conducteur comprend des mailles cubiques, le taux de cet élément du semi-conducteur des troisièmes couches varie de manière décroissante d'une troisième couche à l'autre selon une direction allant de la première couche au substrat. Autrement dit, en considérant deux troisièmes couches au sein du premier empilement, le taux de cet élément dans l'une de ces deux troisièmes couches qui est la plus proche de la première couche est supérieur au taux de cet élément dans l'autre de ces deux troisièmes couches.

Lorsque la structure cristalline du semi-conducteur comprend des mailles hexagonales, le taux de cet élément du semi-conducteur des troisièmes couches est sensiblement constant dans toutes les troisièmes couches. Cette configuration permet l'ajout d'une contrainte compressive sans générer de dislocations car dans un tel semi-conducteur, il n'y a pas de plan de glissement, sauf parallèle à la croissance dans la direction <0001>. Cette contrainte compressive permet notamment de compenser la différence de CTE entre les matériaux, par exemple entre le GaN et le silicium, pendant le refroidissement après croissance.

Un semi-conducteur du groupe III-V correspond à un semi-conducteur comportant un ou plusieurs éléments appartenant à la colonne III A, ou 13, et un ou plusieurs éléments appartenant à la colonne V A, ou 15, du tableau périodique des éléments, ou table de Mendeleïev.

Un semi-conducteur du groupe II-VI correspond à un semi-conducteur comportant un ou plusieurs éléments appartenant à la colonne II B, ou 12, et un ou plusieurs éléments appartenant à la colonne VI A, ou 16, du tableau périodique des éléments.

L'épaisseur de chacune des deuxièmes et troisièmes couches est inférieure à une épaisseur critique au-delà de laquelle un phénomène de relaxation se produit et qui se traduit par la formation de dislocations et d'états d'interface. Cela est notamment vérifier en réalisant les deuxièmes et troisièmes couches avec une épaisseur inférieure à environ 5 nm. En évitant une telle relaxation dans les couches, un effet correspondant à une contrainte qui augmente de façon contrôlée et continue est obtenu.

En interposant plusieurs empilements, formant chacun un super-réseau, entre la première couche et le substrat, de nombreuses interfaces de différents matériaux sont interposées entre la première couche et le substrat, ce qui permet d'augmenter l'épaisseur totale de la structure semi-conductrice sans la fragiliser. Dans cette configuration, le deuxième empilement des deuxièmes et troisièmes couches de semi-conducteur disposé sur la quatrième couche de semi-conducteur permet d'appliquer une contrainte compressive sur cette quatrième couche de semi-conducteur et d'obtenir au final une structure plus épaisse munie à son sommet d'une première couche plus épaisse qui est par exemple compatible avec la réalisation d'un transistor apte à supporter des tensions électriques de valeurs plus importantes qu'une couche d'un même semi-conducteur mais plus fine. D'un point de vue électrique, cette configuration avec de très nombreuses interfaces permet donc d'améliorer la tenue en tension d'un dispositif électrique et/ou électronique réalisé à partir d'une telle structure semi-conductrice, tout en réduisant les fuites de courant au sein de cette structure.

De plus, la couche de relaxation d'AIN disposée entre la quatrième couche et le deuxième empilement permet de relaxer les contraintes sur le paramètre de maille entre la quatrième couche et de le deuxième empilement, facilitant ainsi la croissance du super-réseau correspondant au deuxième empilement sur la couche de relaxation, et réduisant encore plus les courants de fuite au sein de la structure en raison de l'amélioration de l'efficacité des interfaces.

Le deuxième empilement peut être similaire ou non au premier empilement.

La structure semi-conductrice peut être telle qu'elle comporte :
- n deuxièmes empilements de plusieurs deuxièmes et troisièmes couches disposées de manière alternée les unes sur les autres et comportant ledit semi-conducteur, disposés entre le premier empilement et la première couche,
- n quatrièmes couches de semi-conducteur de composition sensiblement identique à celle du semi-conducteur de la première couche et telles que l'une des quatrièmes couches soit disposée sur et contre le premier empilement, et que la ou chacune des autres quatrièmes couches soit disposée sur et contre l'un des autres deuxièmes empilements,
- plusieurs couches de relaxation comprenant de l'AlN et chacune disposée entre l'une des quatrièmes couches et l'un des deuxièmes empilements,
avec n nombre entier compris entre 2 et 19.

En multipliant ainsi le nombre d'empilements, et donc de super-réseaux, au sein de la structure semi-conductrice, les courants de fuite au sein de la structure semi-conductrice sont réduits et cela permet d'augmenter la valeur de la tension de claquage d'un dispositif électrique / électronique qui comporte une telle structure semi-conductrice.

Les deuxièmes empilements peuvent être similaires ou non les uns des autres.

Le semi-conducteur est de l'Al_{X}Ga_{Y}In(_{1-X-Y})N, avec 0 ≤ X < 1, 0 < Y ≤ 1 et (X + Y) ≤ 1. Un tel semi-conducteur correspond à un semi-conducteur de type III-V comprenant une structure cristalline à mailles hexagonales.

La quatrième couche ou chacune des quatrièmes couches peut avoir une épaisseur comprise entre environ 0,5 et 1,5 fois l'épaisseur de l'empilement sur et contre lequel la quatrième couche est disposée.

Le semi-conducteur de la première couche peut être du GaN, et/ou le semi-conducteur des deuxièmes couches peut être de l'Al_{X}Ga_{(1-X)}N (ce qui correspond à de l'Al_{X}Ga_{Y}In_{(1-X-Y)}N avec X + Y = 1), et/ou le semi-conducteur des troisièmes couches peut être du GaN.

Dans chacun des premier et deuxième(s) empilements, le semi-conducteur des deuxièmes couches peut être de l'Al_{X}Ga_{(1-X)}N tel que X varie d'environ 1 à environ 0,3 d'une deuxième couche à l'autre selon une direction allant du substrat à la première couche.

Dans un ou plusieurs des premier et deuxième empilements, des cinquièmes couches comprenant de l'AlN ou de l'AlGaN de composition différente de celle du semi-conducteur des deuxièmes et troisièmes couches peuvent être interposées entre des groupes de couches formés chacun d'une deuxième et d'une troisième couches. Ainsi, dans ce ou ces empilements, une telle cinquième couche d'AIN ou d'AlGaN peut être interposée entre deux groupes de couches formés chacun d'une deuxième et d'une troisième couches. Chacune des cinquièmes couches peut être disposée sur une troisième couche d'un de ces groupes de couches. Ces interfaces supplémentaires entre l'AlN ou l'AlGaN des cinquièmes couches et le semi-conducteur des troisièmes couches, par exemple en GaN, permettent de réduire encore plus les courants de fuite au sein des empilements.

La structure semi-conductrice peut comporter en outre une première couche tampon comprenant de l'AlN et disposée entre le substrat et le premier empilement.

De manière avantageuse, l'épaisseur de chacune des deuxièmes et troisièmes couches peut être inférieure à environ 2 nm.

Les épaisseurs des deuxièmes couches peuvent être sensiblement similaires les unes par rapport aux autres et/ou les épaisseurs des troisièmes couches peuvent être sensiblement similaires les unes par rapport aux autres.

Le substrat peut comporter du silicium monocristallin.

L'épaisseur totale du premier empilement et/ou l'épaisseur totale du ou de chacun des deuxièmes empilements peut être inférieure ou égale à environ 5 µm.

La structure semi-conductrice peut comporter en outre au moins :
- un deuxième empilement de plusieurs deuxièmes et troisièmes couches disposées de manière alternée l'une contre l'autre et sensiblement similaires aux deuxièmes et troisièmes couches du premier empilement, disposé entre le premier empilement et la première couche,
- une quatrième couche de semi-conducteur de composition sensiblement similaire à la celle du semi-conducteur de la première couche et disposée entre les premier et deuxième empilements.

L'invention concerne également un procédé de réalisation d'une structure semi-conductrice telle que définie ci-dessus, dans lequel au moins les première, deuxièmes, troisièmes et quatrième couches et la couche de relaxation sont réalisées par épitaxie par jet moléculaire ou par épitaxie en phase vapeur.

L'invention porte également sur un dispositif semi-conducteur comportant au moins une structure semi-conductrice telle que définie ci-dessus et une zone, ou région, active comprenant la première couche de la structure semi-conductrice ou disposée sur la première couche de la structure semi-conductrice.

Ledit dispositif semi-conducteur peut comporter au moins une diode électroluminescente et/ou au moins un transistor comprenant la zone active.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une structure semi-conductrice selon un premier exemple de réalisation ;
- la figure 2 représente une variation du taux de gallium dans le semi-conducteur des couches de la structure semi-conductrice selon le premier exemple de réalisation ;
- la figure 3 représente une variation du taux de gallium dans le semi-conducteur des couches d'une structure semi-conductrice selon un deuxième exemple de réalisation ;
- la figure 4 représente une structure semi-conductrice, objet de la présente invention, selon un premier mode de réalisation ;
- la figure 5 représente schématiquement un transistor de puissance formé sur une structure semi-conductrice, objet de la présente invention, selon un mode de réalisation particulier;
- la figure 6 représente schématiquement une diode électroluminescente formée sur une structure semi-conductrice, objet de la présente invention, selon un mode de réalisation particulier;
- les figures 7 et 8 représentent des courants de fuite obtenus dans une structure semi-conductrice, objet de la présente invention ;
- la figure 9 représente une variation du taux de gallium dans le semi-conducteur des couches d'un empilement d'une structure semi-conductrice, objet de la présente invention, selon une variante avantageuse.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

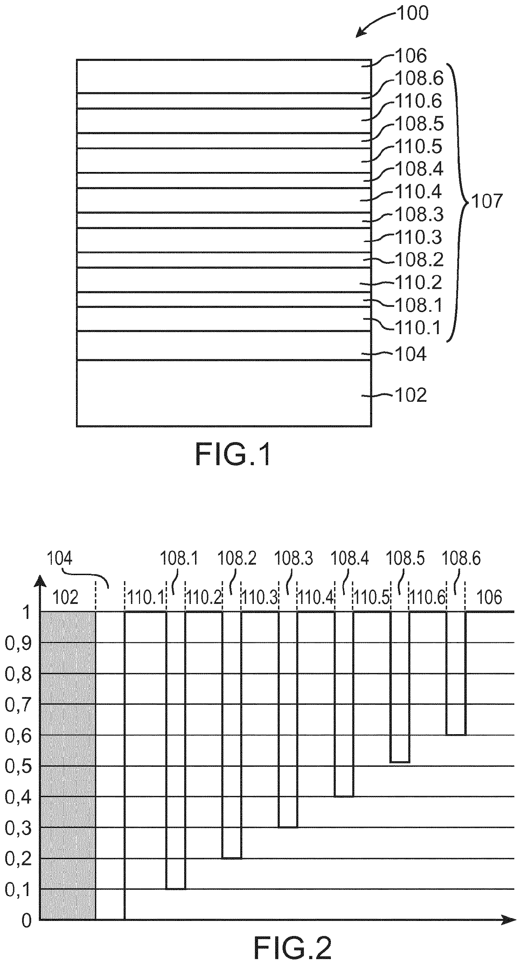

On se réfère tout d'abord à la figure 1 qui représente une structure semi-conductrice 100 selon un premier exemple de réalisation.

La structure 100 comporte un substrat 102 à partir duquel les autres couches de semi-conducteur de la structure 100 sont réalisées. Dans ce premier exemple de réalisation, le substrat 102 comporte du silicium monocristallin de type (111) dont l'épaisseur est de plusieurs microns ou plusieurs dizaines ou centaines de microns. En variante, le substrat 102 peut comporter d'autres matériaux comme par exemple du saphir ou du SiC.

Une couche tampon 104 est disposée sur le substrat 102 et sert de couche de nucléation pour la croissance des autres couches semi-conductrices de la structure 100. La couche tampon 104 comporte par exemple de l'AlN et une épaisseur pouvant être comprise entre environ 5 nm et 1 µm, par exemple égale à environ 200 nm. Cette couche tampon 104 a également pour rôle de protéger le substrat 102 vis-à-vis des températures élevées mises en jeu pour la réalisation des autres couches de semi-conducteur de la structure 100.

La structure 100 comporte également une première couche 106 de semi-conducteur disposée au sommet de la structure 100. Cette première couche 106 comporte le semi-conducteur destiné à servir à la réalisation de zones ou de régions actives de dispositifs semi-conducteurs. Le semi-conducteur de la première couche 106 correspond à un semi-conducteur du groupe III-V et qui comprend une structure cristalline à mailles hexagonales. Le semi-conducteur de la première couche 106 est avantageusement du GaN qui est un semi-conducteur III-V de structure cristalline à mailles hexagonales. En variante, le semi-conducteur de la première couche 106 peut correspondre par exemple à de l'AlGaN ou de l'AlGaInN qui sont également des semi-conducteurs III-V de structures cristallines à mailles hexagonales. Selon une autre variante non revendiquée, la première couche 106 peut comporter un semi-conducteur III-V de structure cristalline à mailles cubiques, comme par exemple du GaAs ou de l'InP. Selon une autre variante non revendiquée, la première couche 106 peut comporter un semi-conducteur II-VI de structure cristalline à mailles hexagonales, comme par exemple du ZnO, ou de structure cristalline à mailles cubiques, comme par exemple du ZnS ou du ZnSe.

L'épaisseur de la première couche 106 est choisie en fonction de la future utilisation du semi-conducteur de cette couche 106. Ainsi, lorsque la première couche 106 est destinée à servir à la réalisation de zones actives de transistors de type HEMT et à supporter des tensions de plusieurs centaines de volts, l'épaisseur de la première couche 106 est par exemple égale à environ 2 µm.De manière générale, l'épaisseur de la première couche 106 peut être comprise entre environ 100 nm et 5 µm.

Du fait que le paramètre de maille du matériau du substrat 102 est différent de celui du semi-conducteur de la première couche 106, et pour pouvoir réaliser la première couche 106 telle que le semi-conducteur de cette couche soit de bonne qualité, suffisamment contraint en compression, avec une épaisseur suffisante et permette d'avoir une bonne tenue en tension, un empilement alterné de deuxièmes couches de semi-conducteur 108 et de troisièmes couches de semi-conducteur 110 est réalisé au préalable sur le substrat 102, la première couche 106 étant disposée sur cet empilement de couches 108, 110. Cet empilement porte la référence 107 sur la figure 1

L'épaisseur de chacune des couches 108, 110 est ici comprise entre environ 0,5 nm, c'est-à-dire environ l'épaisseur de deux monocouches, et 5 nm. De préférence, l'épaisseur de chacune des couches 108, 110 est inférieure ou égale à environ 2 nm, voir inférieure ou égale à environ 1 nm. Les épaisseurs des deuxièmes couches 108 peuvent être similaires entre elles, comme c'est le cas sur la figure 1, ou être au moins en partie différentes les unes des autres. De même, les épaisseurs des troisièmes couches 110 peuvent être similaires entre elles, comme c'est le cas sur la figure 1, ou être différentes au moins en partie les unes des autres. Enfin, les épaisseurs des deuxièmes couches 108 peuvent être similaires ou différentes (cas de la figure 1) de celles des troisièmes couches 110. L'épaisseur de chacune des couches 108, 110 est inférieure à son épaisseur critique au-delà de laquelle se produit une relaxation pouvant se traduire par la formation de dislocations dans le matériau ou d'états d'interface aux interfaces avec les autres couches. Cette épaisseur critique dépend de la nature du semi-conducteur de ces couches. Par exemple, pour de l'AlN disposé sur du GaN, celui-ci commence à relaxer à partir d'une épaisseur égale à environ 2 nm.

Sur l'exemple de la figure 1, seules six deuxièmes couches 108, référencées 108.1 à 108.6, et six troisièmes couches 110, référencées 110.1 à 110.6, sont représentées. Toutefois, la structure 100 comporte généralement un nombre total de couches 108, 110 bien plus important que sur l'exemple de la figure 1, par exemple environ 500 ou plus généralement compris entre environ 150 et 2000. Le nombre total de couches 108, 110 de l'empilement 107 est notamment fonction des épaisseurs choisies pour ces couches ainsi que de l'épaisseur totale souhaitée pour cet empilement 107 de couches (qui dépend elle-même de l'épaisseur souhaitée pour la première couche 106) qui est généralement inférieure ou égale à environ 5 µm.

Dans ce premier exemple de réalisation, les troisièmes couches 110 comportent du GaN, et les deuxièmes couches 108 comportent de l'Al_{X}Ga_{(1-X)}N dont le taux de gallium (1-X) varie d'une deuxième couche 108 à l'autre. En effet, d'une couche 108 à l'autre, ce taux de gallium varie de manière croissante dans le sens allant du substrat 102 à la première couche 106. Ainsi la deuxième couche 108 qui est la plus proche du substrat 102 (la couche 108.1 sur l'exemple de la figure 1) peut avoir un taux de gallium proche de zéro, par exemple compris entre environ 0 et 0,2. La deuxième couche 108 qui est la plus proche de la première couche 106 (la couche 108.6 sur l'exemple de la figure 1) peut avoir un taux de gallium par exemple compris entre environ 0,6 et 0,1, et par exemple égal à 0,5. Typiquement, le taux de gallium des compositions moyennes des deux couches finales (couches 110.6 et 108.6 sur l'exemple de la figure 1) est choisi supérieur à environ 0,2 pour assurer la compression de la couche 106. De manière générale, en considérant deux deuxièmes couches 108 au sein de l'empilement 107, le taux de gallium dans l'une de ces deux deuxièmes couches 108 qui est la plus proche du substrat 102 est inférieur au taux de gallium dans l'autre de ces deux deuxièmes couches 108.

Dans le semi-conducteur des troisièmes couches 110, le taux de gallium est sensiblement constant (et ici égal à 1).

Du fait que le GaN des couches 106 et 110 correspond à de l'Al_{X}Ga_{Y}In_{(1-X-Y)}N, avec X = 0 et Y = 1, et que l'AlGaN des couches 108 correspond à de l'Al_{X}Ga_{Y}In_{(1-X-Y)}N, avec X + Y = 1, les couches 106, 108, 110 comportent bien chacune un semi-conducteur de nature similaire correspondant à de Al_{X}Ga_{Y}In_{(1-X-Y)}N, ce semi-conducteur étant de type III-V de structure cristalline à mailles hexagonales.

La figure 2 représente la variation du taux de gallium dans le semi-conducteur des différentes couches de la structure 100. Ce taux de gallium est nul dans le substrat 102 et dans la couche tampon 104, et est égal à 1 dans chacune des troisièmes couches 110 et dans la première couche 106. Dans la direction allant du substrat 102 à la première couche 106, le taux de gallium dans les deuxièmes couches 108 augmente régulièrement, couche après couche (augmentation de 0,1 par rapport à la deuxième couche précédente sur cet exemple). Ainsi, le paramètre de maille moyen de chaque groupe formé d'une des deuxièmes couches 108 et d'une des troisièmes couches 110 adjacentes l'une avec l'autre a une valeur variant de manière croissante depuis le substrat 102 jusqu'à la première couche 106. De plus, du fait que la composition du semi-conducteur des deuxièmes couches 108 varie d'une couche à l'autre, la contrainte change également le long de l'empilement 107 des couches 108, 110. La combinaison de ces caractéristiques de l'empilement 107 des couches 108 et 110 permet de réduire le nombre de dislocations apparaissant dans la première couche 106 tout en ayant un bon niveau de contrainte compressive dans cette couche 106, et cela pour une épaisseur relativement importante. Une bonne tenue en tension est également obtenue grâce à cette structure.

En variante de ce premier exemple de réalisation, il est possible que dans la direction allant du substrat 102 à la première couche 106, le taux de gallium dans les troisièmes couches 110 diminue régulièrement d'une troisième couche à l'autre. Cette diminution du taux de gallium d'une troisième couche 110 à l'autre est toutefois moins importante que l'augmentation du taux de gallium dans les deuxièmes couches 108 dans ce même sens afin que le paramètre de maille moyen de chaque groupe formé d'une des deuxièmes couches 108 et d'une des troisièmes couches 110 adjacentes l'une avec l'autre ait une valeur variant de manière croissante depuis le substrat 102 jusqu'à la première couche 106. Cette variation de la composition du matériau des troisièmes couches 110 contribue au changement de la contrainte le long de l'empilement des couches 108 et 110. Comme précédemment, la combinaison de ces caractéristiques de l'empilement 107 des couches 108 et 110 permet de réduire le nombre de dislocations apparaissant dans la première couche 106 tout en ayant un bon niveau de contrainte compressive dans cette couche 106, et cela pour une épaisseur relativement importante. Une bonne tenue en tension est aussi obtenue dans cette structure.

Dans les cas précédemment décrits, la variation de la composition des deuxièmes couches 108 et/ou la variation de la composition des troisièmes couches 110, et donc la variation du paramètre de maille moyen de chaque groupe formé d'une des deuxièmes couches 108 et d'une des troisièmes couches 110 adjacentes l'une de l'autre, peuvent être linéaires ou non.

Dans un deuxième exemple de réalisation non revendiqué, le semi-conducteur des couches 106, 108 et 110 peut correspondre à un semi-conducteur du groupe III-V ou II-VI qui comprend une structure cristalline à mailles cubiques. Un tel semi-conducteur est par exemple de l'Al_{X}Ga_{1-X}As. Dans ce cas, la couche tampon 104 comporte par exemple de l'AlAs ou du GaAs, la première couche 106 comporte du GaAs, et les deuxièmes et troisièmes couches 108 et 110 comportent de l'AlGaAs dans lesquelles le taux de gallium varie couche après couche aussi bien pour les deuxièmes couches 108 que pour les troisièmes couches 110. En effet, du fait que le semi-conducteur des couches 106, 108, 110 comporte une structure cristalline à mailles cubiques, l'empilement des couches 108 et 110 est réalisé tel que le taux de gallium varie au sein des couches 108 et 110 et tel que la valeur du paramètre de maille moyen de chaque groupe d'une deuxième et d'une troisième couches adjacentes soit sensiblement constante sur toute l'épaisseur de l'empilement des couches 108 et 110.

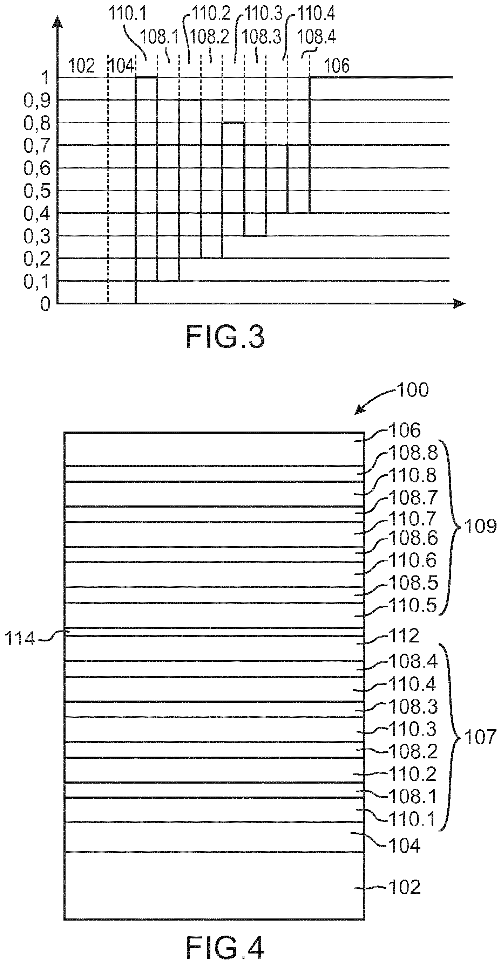

La figure 3 représente un exemple de variation du taux de gallium dans le semi-conducteur des différentes couches de la structure 100 selon ce deuxième exemple de réalisation, dans laquelle l'empilement de couches 108, 110 comporte quatre deuxièmes couches 108.1 à 108.4 et quatre troisièmes couches 110.1 à 110.4. On voit sur cette figure que dans la direction allant du substrat 102 à la première couche 106, le taux de gallium dans les deuxièmes couches 108 augmente régulièrement, couche après couche (pour chaque deuxième couche 108, augmentation de 0,1 par rapport à la deuxième couche 108 précédente sur cet exemple), et que parallèlement, dans cette même direction, le taux de gallium dans les troisièmes couches 110 diminue régulièrement et proportionnellement à l'augmentation du taux de gallium dans les deuxièmes couches 108 (pour chaque troisième couche 110, baisse de 0,1 par rapport à la troisième couche 110 précédente sur cet exemple). Ainsi, le paramètre de maille moyen de chaque groupe formé d'une des deuxièmes couches 108 et d'une des troisièmes couches 110 adjacentes l'une par rapport à l'autre a une valeur sensiblement constante depuis le substrat 102 jusqu'à la première couche 106. L'obtention d'un paramètre de maille moyen de chaque groupe formé d'une des deuxièmes couches 108 et d'une des troisièmes couches 110 adjacentes l'une par rapport à l'autre de valeur sensiblement constante depuis le substrat 108 jusqu'à la première couche 106, tout en ayant des couches 108 et 110 de compositions variables afin d'avoir un changement de la contrainte le long de l'empilement des couches 108 et 110, peut également être obtenu en réalisant les couches 108 et 110 telles que dans la direction allant du substrat 102 à la première couche 106, le taux de gallium dans les troisièmes couches 110 augmente régulièrement, couche après couche, et que parallèlement, dans cette même direction, le taux de gallium dans les deuxièmes couches 108 diminue régulièrement et proportionnellement à l'augmentation du taux de gallium dans les troisièmes couches 110.

Comme dans le premier exemple de réalisation, la variation de la composition des deuxièmes couches 108 et la variation de la composition des troisièmes couches 110 peuvent être linéaires ou non.

Selon un premier mode de réalisation, la structure 100 est telle qu'entre la première couche 106 et la couche tampon 104, plusieurs empilements de couches 108, 110, similaires aux empilements précédemment décrits, soient disposés les uns au-dessus des autres et séparés les uns des autres par des quatrièmes couches de semi-conducteur de composition similaire à celle du semi-conducteur la première couche 106.

La figure 4 représente une structure semi-conductrice 100 selon ce premier mode de réalisation. Ainsi, un premier empilement 107 de deuxièmes couches 108.1 à 108.4 et de troisièmes couches 110.1 à 110.4 d'AlGaN dont les compositions en gallium varient comme précédemment décrit en liaison avec la figure 2 (en ne considérant que les couches 110.1 à 110.4 et 108.1 à 108.4) est disposé sur la couche tampon 104. Une quatrième couche 112 de composition similaire à celle de la première couche 106 (ici en GaN) est disposée sur ce premier empilement 107. Une couche de relaxation 114 comprenant de l'AlN est disposée sur la quatrième couche 112. L'épaisseur de la couche de relaxation 114 est par exemple comprise entre environ 5 nm et 50 nm, par exemple égale à environ 15 nm. Un deuxième empilement 109 de deuxièmes couches 108.5 à 108.8 et de troisièmes couches 110.5 à 110.8, ici similaire au premier empilement 107, est disposé sur la couche de relaxation 114. La première couche 106 est formée sur ce deuxième empilement 109.

La répétition de l'empilement de couches 108, 110 au sein de la structure 100 permet d'appliquer une contrainte sur la quatrième couche 112 et d'obtenir ainsi une structure semi-conductrice 100 plus épaisse permettant la réalisation d'une première couche 106 d'épaisseur plus importante, par exemple pour la réalisation d'un dispositif semi-conducteur tel qu'un transistor pouvant supporter des tensions électriques de valeurs plus importantes qu'avec une structure ne comportant pas cette répétition d'empilements des deuxièmes et troisièmes couches 108, 110.

L'insertion de la couche de relaxation 114 entre la quatrième couche 112 et le deuxième empilement 109 permet de relaxer les contraintes sur le paramètre de maille entre la quatrième couche 112 et de le deuxième empilement 109, facilitant ainsi la croissance du deuxième empilement 109 sur la couche de relaxation, et réduisant encore plus les courants de fuite au sein de la structure 100.

De plus, comme précédemment, chaque empilement 107, 109 des couches 108, 110 comporte généralement un nombre de couches bien plus important que celles représentées sur la figure 4.

Sur la figure 4, deux empilements 107, 109 de couches 108, 110, séparés l'un de l'autre par la quatrième couche 112 et la couche de relaxation 114, sont disposés entre le substrat 102 et la première couche 106. Il est toutefois possible qu'un nombre plus important d'empilements de couches 108, 110, c'est-à-dire plusieurs deuxièmes empilements 109 disposés entre le premier empilement 107 et la première couche 106, et donc également plusieurs quatrièmes couches 112 et plusieurs couches de relaxation 114 chacune interposée entre deux deuxièmes empilements 109, soit superposés et disposés entre le substrat 102 et la première couche 106.

Dans tous les cas, le premier empilement 107 et les deuxièmes empilements 109 peuvent être similaires ou non les uns des autres, notamment en termes de nombre de deuxièmes et troisièmes couches 108, 110, épaisseur totale, taux de Ga dans les deuxièmes et troisièmes couches 108, 110, etc.

L'épaisseur de chaque quatrième couche 112 peut être comprise entre environ 0,5 et 1,5 fois l'épaisseur de l'empilement 107 ou 109 sur lequel repose la quatrième couche 112.

De manière avantageuse, la structure 100 peut comporter entre 1 et 19 deuxièmes empilements 109.

Quel que soit le mode de réalisation ou la variante de réalisation, les différentes couches de la structure semi-conductrice 100 sont réalisées par croissance, notamment par épitaxie par jet moléculaire ou par épitaxie en phase vapeur. Ces étapes de croissance peuvent être mises en oeuvre à basse pression, par exemple à environ 75 mbar, à une température égale à environ 1000°C et sous une pression partielle d'ammoniac d'environ 10 mbar pour les couches 108, 110. Par exemple, pour une croissance de couches de nature similaire à celles du premier mode de réalisation précédemment décrit (à base de GaN), la croissance des couches peut être réalisée avec une pression comprise entre environ 25 mbar et 1000 mbar et une température comprise entre environ 900°C et 1100°C. Pour une croissance de couches de nature similaire à celles du deuxième exemple de réalisation (à base de GaAs), la croissance des couches peut être réalisée avec une pression comprise entre environ 25 mbar et 1000 mbar et une température comprise entre environ 500°C et 700°C.

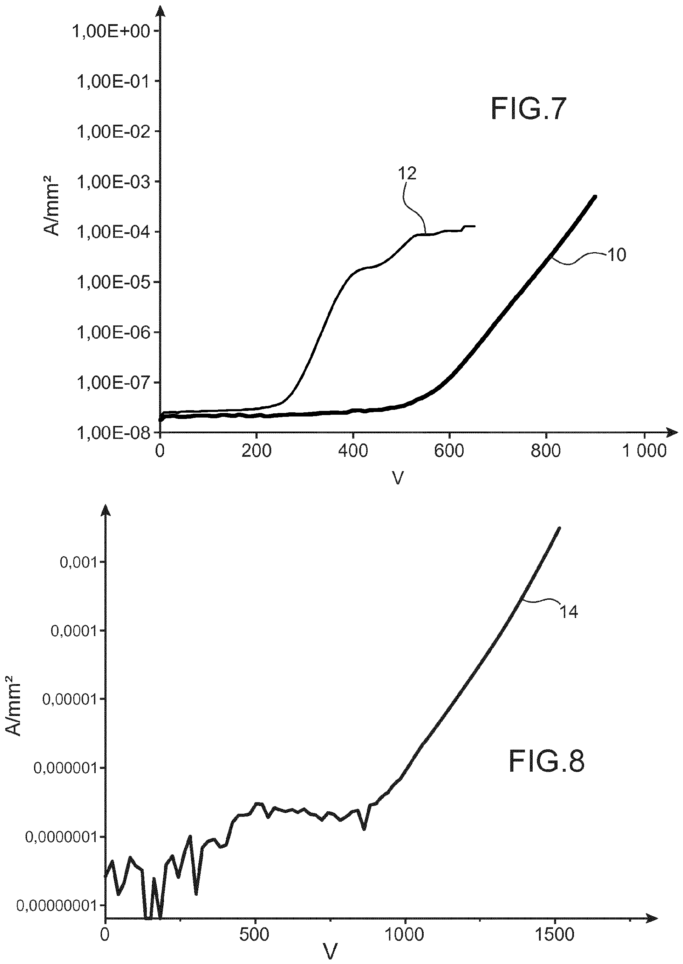

La courbe 10 représentée sur la figure 7 représente les courants de fuite obtenus jusqu'à la tension maximale de claquage dans une structure 100 telle que celle précédemment décrite en liaison avec la figure 4, comportant plusieurs empilements 107, 109 formés au total de 340 deuxièmes et troisièmes couches 108, 110, la structure 100 ayant une épaisseur totale d'environ 3,6 µm. A titre de comparaison, la courbe 12 représente les courants de fuite obtenus jusqu'à la tension maximale de claquage dans une structure d'épaisseur analogue mais ne comportant pas les empilements 107, 109.

Ces courbes montrent que l'ajout des empilements 107, 109 couplés à la ou aux quatrièmes couches 112 et à la ou aux couches de relaxation 114 permet d'obtenir une tension de claquage de valeur plus importante (gain de 250 V entre les courbes 10 et 12) et d'obtenir, pour une valeur de tension donnée, des courants de fuite plus faibles (par exemple gain d'un facteur 1000 à une tension de 600 V).

Sur la figure 8, la courbe 14 représente les courants de fuite obtenus dans une structure 100 telle que celle précédemment décrite en liaison avec la figure 4, mais comportant un premier empilement 107 et deux deuxièmes empilements 109 (avec trois quatrièmes couches 112 et deux couches de relaxation 114 disposées entre les empilements, l'épaisseur totale des couches interposées entre le substrat 102 et la première couche 106 étant d'environ 6,5 µm.On voit que la tension de claquage d'une telle structure 100 est supérieure à 1500 V et que des courants de fuite faibles, ici inférieurs à environ 5 µA/mm², sont obtenus pour des tensions inférieures à environ 1200 V.

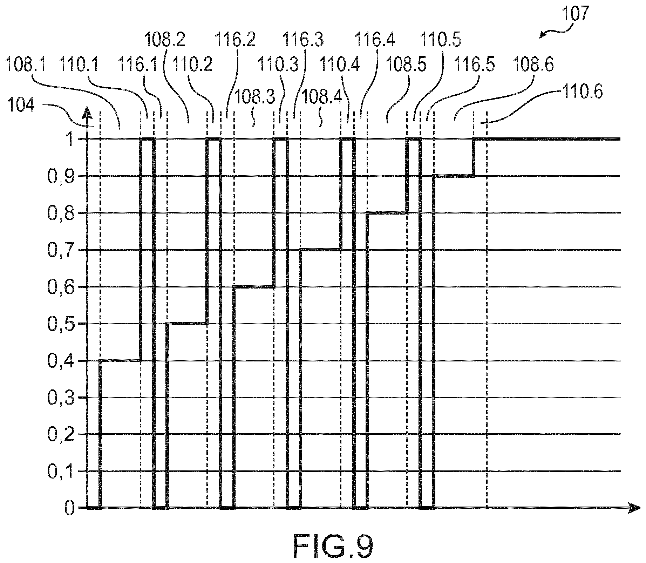

Dans une variante avantageuse, il est possible que dans un ou plusieurs des empilements 107, 109 de la structure 100, en plus des deuxièmes et troisièmes couches 108, 110, une cinquième couche 116 d'AlN ou d'AlGaN de composition différente de celle du semi-conducteur des deuxièmes et troisièmes couches 108, 110 soit insérée entre chaque groupe formé d'une deuxième couche 108 et d'une troisième couche 110. La figure 9 représente un exemple de variation du taux de gallium dans le semi-conducteur des différentes couches d'un des empilements d'une structure 100 selon cette variante avantageuse, par exemple ici le premier empilement 107. Dans ce premier empilement 107 formé sur la couche tampon 104, un premier groupe d'une deuxième couche 108.1 et d'une troisième couche 110.1 est formé sur la couche tampon 104. Une cinquième couche 116.1, comportant ici de l'AlN, est formée sur la troisième couche 110.1. Un deuxième groupe d'une deuxième couche 108.2 et d'une troisième couche 110.2 est formée sur la cinquième couche 116.1. Une autre cinquième couche 116.2, comportant également de l'AlN, est formée sur la troisième couche 110.2. Cette structure comportant un groupe d'une deuxième couche 108 et d'une troisième couche 110 et une cinquième couche 116 est répétée plusieurs fois pour former le premier empilement 107. Dans cet exemple, les six deuxièmes couches 108.1 à 108.6 ont un taux de gallium variant, d'une deuxième couche à l'autre, de 0,4 à 0,9.

En insérant ces cinquièmes couches 116 comportant de l'AlN ou de l'AlGaN au sein d'un ou plusieurs des empilements 107, 109, la croissance des matériaux des couches est facilitée. De plus, les interfaces formées entre les troisièmes couches 110 de GaN et les cinquièmes couches 116 d'AlN ou d'AlGaN permettent de réduire encore les courants de fuite dans ce ou ces empilements.

D'autres couches peuvent également être interposées au sein d'un ou plusieurs des empilements 107, 109, formant par exemple des structures de trois, quatre, cinq voire même six couches répétées pour former cet ou ces empilements pour faciliter la croissance des différentes couches de la structure 100, améliorer la tenue en tension et réduire les courants de fuite au sein de la structure 100.

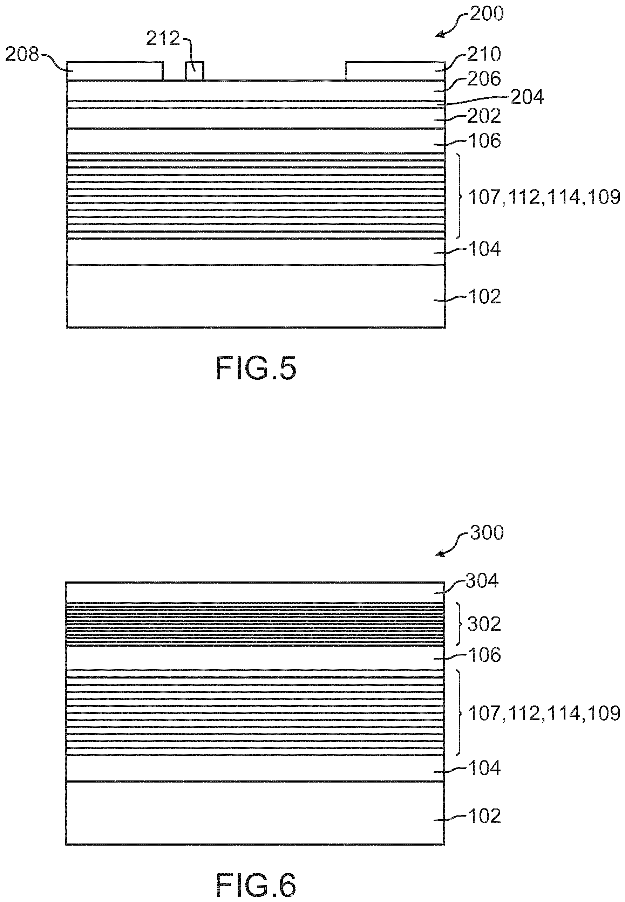

La première couche 106 obtenue peut être utilisée en tant que couche active de dispositifs semi-conducteurs réalisés à partir du substrat formé par la structure 100. Par exemple, un transistor HEMT 200 peut être réalisé à partir de la première couche 106 en GaN, comme représenté schématiquement sur la figure 5. Cette première couche 106 est dopée, par exemple avec du carbone et avec une concentration par exemple égale à environ 10¹⁹ cm⁻³. Une couche supplémentaire 202 comprenant un semi-conducteur similaire à celui de la première couche 106 et plus fine que la première couche 106 (épaisseur par exemple égale à environ 100 nm, ou comprise entre environ 25 nm et 1 µm), et comportant également du carbone en tant que dopant avec une concentration par exemple égale à environ 5.10¹⁶ cm⁻³, est formée sur la première couche 106. Cette couche supplémentaire 202 de GaN est destinée à former le canal du transistor HEMT 200. Une couche espaceur 204, comportant par exemple de l'AlN et d'épaisseur égale à environ 1 nm, est ensuite disposée sur la couche supplémentaire 202 de GaN.

Enfin, une couche d'AlGaN 206, comportant par exemple un taux de gallium égal à environ 80 % et permettant d'assurer la formation d'un gaz d'électrons bidimensionnel dans le canal du transistor 200, est formée sur cette couche espaceur 204. Le transistor HEMT 200 est ensuite achevé par des étapes classiques telles que la formation des régions de source 208 et de drain 210, des contacts métalliques, de la grille 212, etc.

La première couche 106 obtenue peut également être utilisée en tant que couche active d'une diode électroluminescente 300 comme représenté par exemple sur la figure 6. Dans ce cas, la première couche 106 de GaN peut être dopée n. Une structure à puits quantiques 302 comportant des couches barrières de GaN et des couches émissives d'InGaN est ensuite formée sur la première couche 106. Une couche 304 de GaN dopée p peut enfin être réalisée sur la structure à puits quantiques 302. L'invention est définie par les revendications.

## Revendications

1. Structure semi-conductrice (100) comportant au moins :
- un substrat (102),
- une première couche (106) d'un semi-conducteur qui est de l'Al_{X}Ga_{Y}In_{(1-X-Y)}N, avec 0 ≤ X < 1, 0 < Y ≤ 1 et (X + Y) ≤ 1, disposée sur le substrat (102) et telle que ledit semi-conducteur comprend un paramètre de maille différent de celui du matériau du substrat (102),
- des premier et deuxième empilements (107, 109) de plusieurs deuxièmes et troisièmes couches (108, 110) disposées de manière alternée les unes sur les autres et comportant ledit semi-conducteur, le premier empilement (107) étant disposé entre le substrat (102) et la première couche (106), et le deuxième empilement (109) étant disposé entre le premier empilement (107) et la première couche (106),
- une quatrième couche (112) de semi-conducteur de composition identique à celle du semi-conducteur de la première couche (106) et disposée entre les premier et deuxième empilements (107, 109),
- une couche de relaxation (114) comprenant de l'AlN et disposée entre la quatrième couche (112) et le deuxième empilement (109),
et dans laquelle, dans chacun des premier et deuxième empilements (107, 109) :
- le taux de Ga du semi-conducteur des deuxièmes couches (108) varie de manière croissante d'une deuxième couche à l'autre selon une direction allant du substrat (102) à la première couche (106),
- le taux de Ga du semi-conducteur des troisièmes couches (110) est constant ou varie de manière décroissante d'une troisième couche à l'autre selon ladite direction tel que le paramètre de maille moyen de chaque groupe d'une deuxième et d'une troisième couches (108, 110) adjacentes ait une valeur variant de manière croissante d'un groupe à l'autre de l'empilement selon ladite direction,
- l'épaisseur de chacune des deuxièmes et troisièmes couches (108, 110) est inférieure à 5 nm.

2. Structure semi-conductrice (100) selon la revendication 1, comportant :
- n deuxièmes empilements (109) de plusieurs deuxièmes et troisièmes couches (108, 110) disposées de manière alternée les unes sur les autres et comportant ledit semi-conducteur, disposés entre le premier empilement (107) et la première couche (106),
- n quatrièmes couches (112) de semi-conducteur de composition identique à celle du semi-conducteur de la première couche (106) et telles que l'une des quatrièmes couches (112) soit disposée sur et contre le premier empilement (107), et que la ou chacune des autres quatrièmes couches (112) soit disposée sur et contre l'un des autres deuxièmes empilements (109),
- plusieurs couches de relaxation (114) comprenant de l'AlN et chacune disposée entre l'une des quatrièmes couches (112) et l'un des deuxièmes empilements (109),
avec n nombre entier compris entre 2 et 19.

3. Structure semi-conductrice (100) selon l'une des revendications précédentes, dans laquelle la quatrième couche (112) ou chacune des quatrièmes couches (112) a une épaisseur comprise entre 0,5 et 1,5 fois l'épaisseur de l'empilement (107, 109) sur et contre lequel la quatrième couche (112) est disposée.

4. Structure semi-conductrice (100) selon l'une des revendications précédentes, dans laquelle le semi-conducteur de la première couche (106) est du GaN, et/ou le semi-conducteur des deuxièmes couches (108) est de l'Al_{X}Ga_{(1-X)}N, et/ou le semi-conducteur des troisièmes couches (110) est du GaN.

5. Structure semi-conductrice (100) selon l'une des revendications précédentes, dans laquelle, dans chacun des premier et deuxième(s) empilements (107, 109), le semi-conducteur des deuxièmes couches (108) est de l'Al_{X}Ga_{(1-X)}N tel que X varie de 1 à 0,3 d'une deuxième couche à l'autre selon une direction allant du substrat (102) à la première couche (106).

6. Structure semi-conductrice (100) selon l'une des revendications précédentes, dans laquelle, dans un ou plusieurs des premier et deuxième empilements, des cinquièmes couches (116) comprenant de l'AlN ou de l'AlGaN de composition différente de celle du semi-conducteur des deuxièmes et troisièmes couches (108, 110), sont interposées entre des groupes de couches formés chacun d'une deuxième et d'une troisième couches (108, 110).

7. Structure semi-conductrice (100) selon l'une des revendications précédentes, comportant en outre une première couche tampon (104) comprenant de l'AlN et disposée entre le substrat (102) et le premier empilement (107).

8. Structure semi-conductrice (100) selon l'une des revendications précédentes, dans laquelle l'épaisseur de chacune des deuxièmes et troisièmes couches (108, 110) est inférieure à 2 nm.

9. Structure semi-conductrice (100) selon l'une des revendications précédentes, dans laquelle les épaisseurs des deuxièmes couches (108) sont identiques les unes par rapport aux autres et/ou les épaisseurs des troisièmes couches (110) sont identiques les unes par rapport aux autres.

10. Structure semi-conductrice (100) selon l'une des revendications précédentes, dans laquelle le substrat (102) comporte du silicium monocristallin.

11. Structure semi-conductrice (100) selon l'une des revendications précédentes, dans laquelle l'épaisseur totale du premier empilement (107) et/ou l'épaisseur totale du ou de chacun des deuxièmes empilements (109) est inférieure ou égale à 5 µm.

12. Procédé de réalisation d'une structure semi-conductrice (100) selon l'une des revendications précédentes, dans lequel au moins les première, deuxièmes, troisièmes et quatrième couches (106, 108, 110, 112) et la couche de relaxation (114) sont réalisées par épitaxie par jet moléculaire ou en phase vapeur.

13. Dispositif semi-conducteur (200, 300) comportant au moins une structure semi-conductrice (100) selon l'une des revendications 1 à 11 et une zone active comprenant la première couche (106) de la structure semi-conductrice (110) ou disposée sur la première couche (106) de la structure semi-conductrice (110).

14. Dispositif semi-conducteur (200, 300) selon la revendication 13, dans lequel ledit dispositif semi-conducteur comporte au moins une diode électroluminescente (300) et/ou au moins un transistor (200) comprenant la zone active.

## Patentansprüche

1. Halbleiterstruktur (100), welche wenigstens umfasst:
- ein Substrat (102),
- eine erste Schicht (106) eines Halbleiters, der Al_{X}Ga_{Y}In_{(1-X-Y)}N ist, mit 0 ≤ X < 1, 0 < Y ≤ 1 und (X + Y) ≤ 1, die auf dem Substrat (102) angeordnet ist, und derart, dass der Halbleiter einen Gitterparameter umfasst, der sich von dem des Substratmaterials (102) unterscheidet,
- einen ersten und einen zweiten Stapel (107, 109) aus mehreren zweiten und dritten Schichten (108, 110), die abwechselnd übereinander angeordnet sind und den Halbleiter umfassen, wobei der erste Stapel (107) zwischen dem Substrat (102) und der ersten Schicht (106) angeordnet ist und der zweite Stapel (109) zwischen dem ersten Stapel (107) und der ersten Schicht (106) angeordnet ist,
- eine vierte Schicht (112) aus einem Halbleiter mit der gleichen Zusammensetzung wie der Halbleiter der ersten Schicht (106) und angeordnet zwischen dem ersten und dem zweiten Stapel (107, 109),
- eine Entspannungsschicht (114), die AIN umfasst und zwischen der vierten Schicht (112) und dem zweiten Stapel (109) angeordnet ist, und wobei in jedem aus erstem und zweitem Stapel (107, 109):
- der Ga-Anteil des Halbleiters der zweiten Schichten (108) von einer zweiten Schicht zur anderen in einer Richtung vom Substrat (102) zur ersten Schicht (106) zunehmend variiert,
- der Ga-Anteil des Halbleiters der dritten Schichten (110) konstant ist oder von einer dritten Schicht zur anderen in dieser Richtung abnehmend variiert, so dass der mittlere Gitterparameter jeder Gruppe einer benachbarten zweiten und dritten Schicht (108, 110) einen Wert aufweist, der in dieser Richtung von einer Gruppe des Stapels zu einer anderen zunehmend variiert,
- die Dicke jeder der zweiten und dritten Schichten (108, 110) kleiner 5 nm ist.

2. Halbleiterstruktur (100) nach Anspruch 1,
umfassend:
- n zweite Stapel (109) aus mehreren zweiten und dritten Schichten (108, 110), die abwechselnd übereinander angeordnet sind und den Halbleiter umfassen, angeordnet zwischen dem ersten Stapel (107) und der ersten Schicht (106),
- n vierte Schichten eines Halbleiters (112) mit identischer Zusammensetzung wie der Halbleiter der ersten Schicht (106) und derart, dass eine der vierten Schichten (112) auf dem und gegen den ersten Stapel (107) angeordnet ist, und dass die oder jede der anderen vierten Schichten (112) auf und gegen einen der anderen zweiten Stapel (109) angeordnet ist,
- mehrere Relaxationsschichten (114), die AlN umfassen und jeweils zwischen einer der vierten Schichten (112) und einem der zweiten Stapel (109) angeordnet sind,
wobei n eine ganze Zahl zwischen 2 und 19 ist.

3. Halbleiterstruktur (100) nach einem der vorhergehenden Ansprüche, wobei die vierte Schicht (112) oder jede der vierten Schichten (112) eine Dicke zwischen dem 0,5- und 1,5-fachen der Dicke des Stapels (107, 109) aufweist, auf dem und gegen den die vierte Schicht (112) angeordnet ist.

4. Halbleiterstruktur (100) nach einem der vorhergehenden Ansprüche, wobei der Halbleiter der ersten Schicht (106) GaN ist, und/oder der Halbleiter der zweiten Schichten (108) Al_{X}Ga_{(1-X)}N ist, und/oder der Halbleiter der dritten Schichten (110) GaN ist.

5. Halbleiterstruktur (100) nach einem der vorhergehenden Ansprüche, wobei in jedem aus erstem und zweitem(n) Stapel(n) (107, 109) der Halbleiter der zweiten Schichten (108) Al_{X}Ga_{(1-X)}N ist, so dass X von einer zweiten Schicht zur anderen in einer Richtung vom Substrat (102) zur ersten Schicht (106) von 1-0,3 variiert.

6. Halbleiterstruktur (100) nach einem der vorhergehenden Ansprüche, wobei in einem oder mehreren aus erstem und zweitem Stapel fünfte Schichten (116), die AlN oder AlGaN mit einer anderen Zusammensetzung als derjenigen des Halbleiters der zweiten und dritten Schichten (108, 110) umfassen, zwischen Gruppen von Schichten eingefügt sind, die jeweils aus einer zweiten und einer dritten Schicht (108, 110) gebildet sind.

7. Halbleiterstruktur (100) nach einem der vorhergehenden Ansprüche, welche ferner eine erste Pufferschicht (104) umfasst, die AIN aufweist und zwischen dem Substrat (102) und dem ersten Stapel (107) angeordnet ist.

8. Halbleiterstruktur (100) nach einem der vorhergehenden Ansprüche, wobei die Dicke jeder der zweiten und dritten Schichten (108, 110) weniger als 2 nm beträgt.

9. Halbleiterstruktur (100) nach einem der vorhergehenden Ansprüche, wobei die Dicken der zweiten Schichten (108) zueinander identisch sind und/oder die Dicken der dritten Schichten (110) zueinander identisch sind.

10. Halbleiterstruktur (100) nach einem der vorhergehenden Ansprüche, wobei das Substrat (102) monokristallines Silizium umfasst.

11. Halbleiterstruktur (100) nach einem der vorhergehenden Ansprüche, wobei die Gesamtdicke des ersten Stapels (107) und/oder die Gesamtdicke des oder jedes der zweiten Stapel (109) kleiner oder gleich 5 µm ist.

12. Verfahren zur Herstellung einer Halbleiterstruktur (100) nach einem der vorhergehenden Ansprüche, wobei mindestens die ersten, zweiten, dritten und vierten Schichten (106, 108, 110, 112) und die Relaxationsschicht (114) durch Molekularstrahl- oder Dampfphasenepitaxie hergestellt werden.

13. Halbleitervorrichtung (200, 300), welche wenigstens eine Halbleiterstruktur (100) nach einem der Ansprüche 1 bis 11 aufweist und einen aktiven Bereich, weicher die erste Schicht (106) der Halbleiterstruktur (110) umfasst oder auf der ersten Schicht (106) der Halbleiterstruktur (110) angeordnet ist.

14. Halbleitervorrichtung (200, 300) nach Anspruch 13, wobei die Halbleitervorrichtung mindestens eine Elektrolumineszenz-Diode (300) und/oder mindestens einen Transistor (200) mit dem aktiven Bereich umfasst.

## Claims

1. Semiconductor structure (100) comprising at least:
- a substrate (102),
- a first semiconductor layer (106) which is Al_{X}Ga_{Y}In_{(1-X-Y)}N, where 0 ≤ X < 1, 0 < Y ≤ 1 and (X + Y) ≤ 1, arranged on the substrate (102) and such that the lattice parameter of said semiconductor is not the same as the lattice parameter of the material of the substrate (102),
- first and second stacks (107, 109) composed of several second and third layers (108, 110) arranged alternately on each other and comprising said semiconductor, the first stack (107) being located between the substrate (102) and the first layer (106), and the second stack (109) being located between the first stack (107) and the first layer (106),
- a fourth semiconductor layer (112) with an identical composition as that of the semiconductor in the first layer (106) and located between the first and the second stacks (107, 109),
- a relaxation layer (114) comprising AIN and located between the fourth layer (112) and the second stack (109),
and in which, in each of the first and the second stacks (107, 109):
- the ratio of Ga in the semiconductor in the second layers (108) increases from one second layer to the next along a direction from the substrate (102) to the first layer (106),
- the ratio of Ga in the semiconductor in the third layers (110) is constant or decreases from one third layer to the next along said direction such that the average lattice parameter of each group of a second layer and an adjacent third layer (108, 110) increases from one group to the next in the first stack along said direction,
- the thickness of each of the second and third layers (108, 110) is less than 5 nm.

2. Semiconductor structure (100) according to claim 1, comprising:
- n second stacks (109) of several second and third layers (108, 110) arranged alternately one above the other and including said semiconductor, located between the first stack (107) and the first layer (106),
- n fourth semiconductor layers (112) with a composition identical to the composition of the semiconductor of the first layer (106) and such that one of the fourth layers (112) is located on and in contact with the first stack (107), and in that the or each of the other fourth layers (112) is located on and adjacent to one of the other second stacks (109),
- several relaxation layers (114) comprising AIN and each located between one of the fourth layers (112) and one of the second stacks (109),
where n is an integer number between 2 and 19.

3. Semiconductor structure (100) according to one of the previous claims, in which the thickness of the fourth layer (112) or each fourth layer (112) is between 0.5 and 1.5 times the thickness of the stack (107, 109) on and in contact with which the fourth layer (112) is located.

4. Semiconductor structure (100) according to one of the previous claims, in which the semiconductor in the first layer (106) is GaN, and/or the semiconductor in the second layers (108) is Al_{X}Ga_{(1-X)}N, and/or the semiconductor in the third layers (110) is GaN.

5. Semiconductor structure (100) according to one of the previous claims, in which, in each of the first and second stacks (107, 109), the semiconductor in the second layers (108) is Al_{X}Ga_{(1-X)}N such that X varies from 1 to 0.3 from one second layer to the next along a direction from the substrate (102) to the first layer (106).

6. Semiconductor structure (100) according to one of the previous claims, in which, in one or several of the first and second stacks, fifth layers (116) comprising AlN or AlGaN with a composition different from the composition of the semiconductor in the second and third layers (108, 110) are interposed between groups of layers each comprising a second and a third layer (108, 110).

7. Semiconductor structure (100) according to one of the previous claims, also comprising a first buffer layer (104) comprising AIN and located between the substrate (102) and the first stack (107).

8. Semiconductor structure (100) according to one of the previous claims, in which the thickness of each of the second and third layers (108, 110) is less than 2 nm.

9. Semiconductor structure (100) according to one of the previous claims, in which the thicknesses of the second layers (108) are identical one to the other and/or the thicknesses of the third layers (110) are identical one to the other.

10. Semiconductor structure (100) according to one of the previous claims, in which the substrate (102) comprises monocrystalline silicon.

11. Semiconductor structure (100) according to one of the previous claims, in which the total thickness of the first stack (107) and/or the total thickness of second stack or of each of the second stacks (109) is less than or equal to 5 µm.

12. Method of making a semiconductor structure (100) according to one of the previous claims, in which at least the first, second, third and fourth layers (106, 108, 110, 112) and the relaxation layer (114) are made by molecular beam epitaxy or by vapour phase epitaxy.

13. Semiconductor device (200, 300) comprising at least one semiconductor structure (100) according to one of claims 1 to 11 and an active zone comprising the first layer (106) of the semiconductor structure (110) or located on the first layer (106) of the semiconducting structure (110).

14. Semiconductor device (200, 300) according to claim 13, in which said semiconductor device comprises at least one light emitting diode (300) and/or at least one transistor (200) including the active zone.
